Europäisches Patentamt

(19) European Patent Office

Office européen des brevets

(11) Publication number: **0 127 097**
**A2**

(12) **EUROPEAN PATENT APPLICATION**

(21) Application number: **84105744.1**

(22) Date of filing: **19.05.84**

(51) Int. Cl.³: **B 67 D 5/58**
**B 67 D 5/60, B 67 D 5/34**
**B 01 D 19/00, G 03 F 7/16**

(30) Priority: **23.05.83 US 497188**

(43) Date of publication of application:
**05.12.84 Bulletin 84/49**

(84) Designated Contracting States:
**AT BE CH DE FR GB IT LI LU NL SE**

(71) Applicant: **UNION CARBIDE CORPORATION**
**Old Ridgebury Road**
**Danbury Connecticut 06817(US)**

(72) Inventor: **de Leeuwe, Marc**
**530 Calle de Sol**
**Aptos, CA 95003(US)**

(74) Representative: **Dipl.-Ing. H.G. Görtz, Dr.-Ing. J.H. Fuchs**
**Patentanwälte**
**Sonnenberger Strasse 100 Postfach 26 26**
**D-6200 Wiesbaden(DE)**

(54) **Liquid chemical dispensing apparatus.**

(57) Apparatus for dispensing liquid chemicals such as photo-resist from containers (100, 200), in particular from collapsible pouch-type containers.

FIG. 2

## LIQUID CHEMICAL DISPENSING APPARATUS

The present invention relates to the dispensing of liquid chemicals such as photoresist, a modified phenolic solution, from collapsible pouch-type containers.

In the course of the manufacture of microcircuits, it is a common and well known practice to coat wafers of silicon with liquid photoresist and this is usually done by continuously pumping the liquid photoresist from its container to the production component through which the wafers are passed to receive a coating of photoresist. It is important that the pumping of photoresist be continuous so that the processing of wafers is not interrupted.

It is an object of the present invention to provide an apparatus which enables the continuous pumping of photoresist from a succession of photoresist containers.

Other objects will be apparent from the following description and claims taken in conjunction with the drawing wherein.

Figure 1 shows a chemical container suitable for use in the present invention.

Figure 2 shows the apparatus of the present invention in conjunction with containers of the type shown in Figure 1 and.

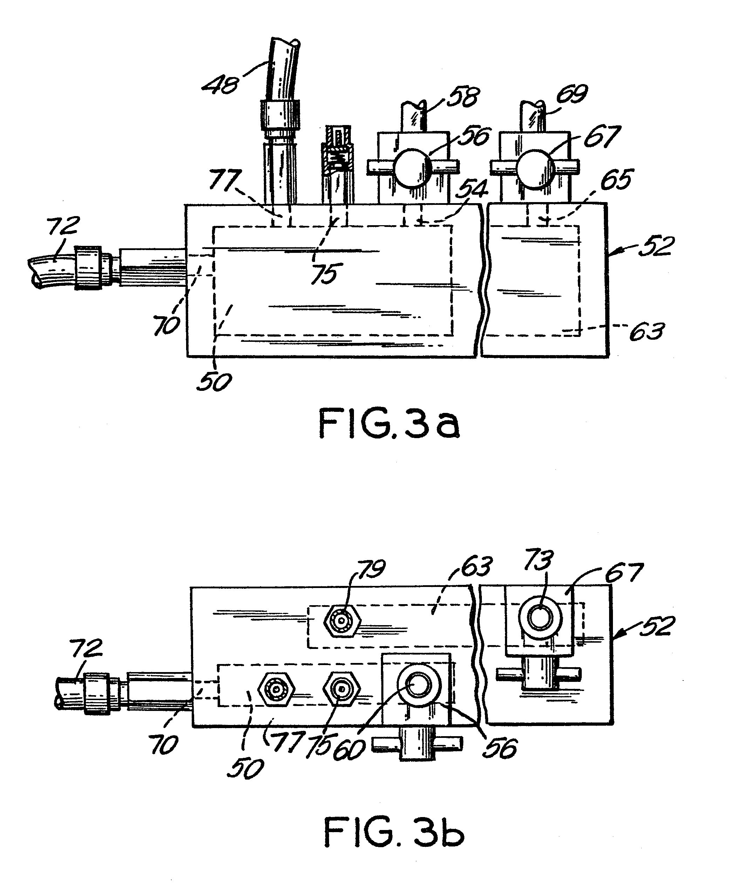

Figures 3(a) and 3(b) show the present invention in more complete detail.

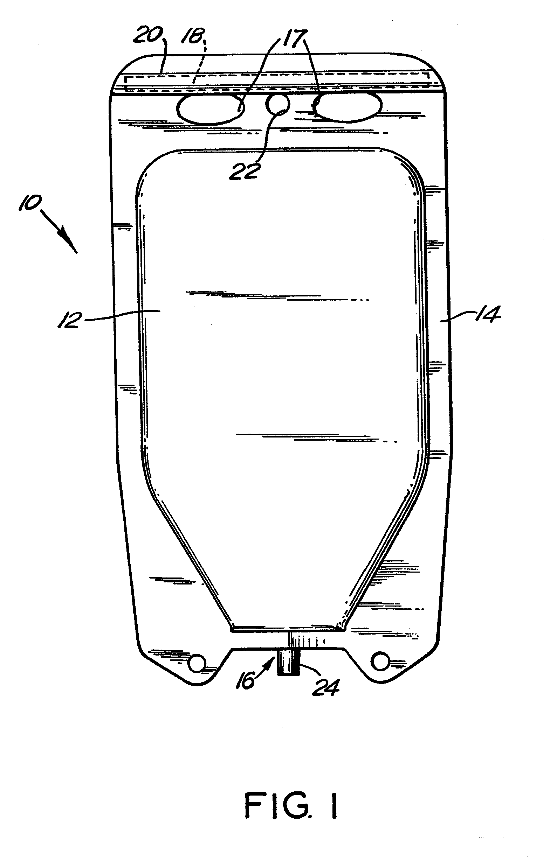

With reference to Figure 1, a pouch-type container for liquid chemicals, such as photoresist, is shown at 10 and comprises a flexible, collapsible pouch 12 suitably formed of plastic laminate sheets of polyethylene and nylon as described in US patent application Ser. No.497,229 filed May 23, 1983. The laminate sheets are heat-sealed to provide a rim 14 and a fill/drain assembly 16 is sealed to the pouch 12. In handling, the pouch is carried at gripping aperatures 17 with support being provided by rod 18 in sleeve 20. When it is desired to use pouch 10 as a source of liquid chemical, e.g., photoresist, the pouch 10 is engaged with a hook through aperature 22 and outlet tube 24 is connected to the photoresist pumping system.

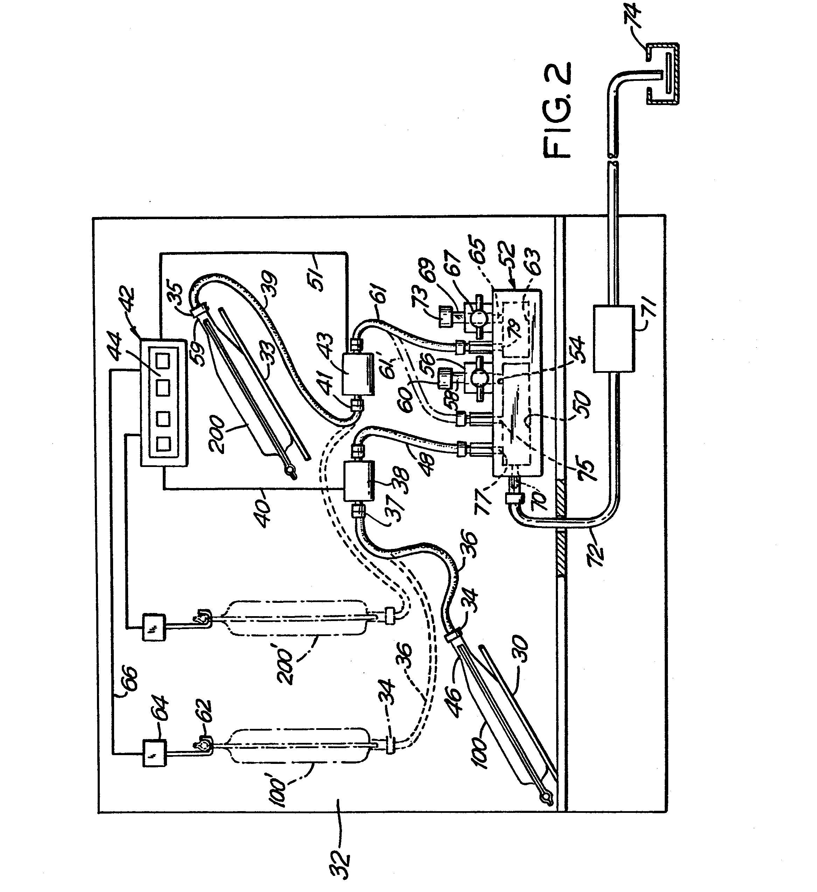

Figure 2 illustrates the apparatus of the present invention with a filled pouch-type container 100 resting on a sloped shelf 30 of a panel 32, e.g., made of sheet metal. Pouch 100 communicates through connector 34, plastic tube 36 and connector 37 to a solenoid controlled valve 38 which is electrically connected via line 40 to control unit 42. An operator by pressing an appropriate switch on panel 44 causes the valve associated with solenoid 38 to open. A slight pressure is then applied to pouch 100 and any gas in the pouch 100 which is present at location 46, on account of the incline of pouch 100 is forced by liquid from pouch 100 through tube 36, valve 38 and tube 48 into chamber 50 of manifold bleeder block 52 which is suitably made from polyethylene but can be made of other materials appropriate for the liquid chemical being handled as is known to those skilled in the art. Pressure is maintained on pouch 100 to cause liquid photoresist to fill chamber 50 and force any gas through conduit 54 and through open hand-operated valve 56. When liquid appears in transparent tube 58, valve 56 is closed and the gas is thus removed. Excess liquid passes to receptacle 60 from which it can be recovered for disposal. Pouch 100 is now moved to the position indicated at 100' and is supported on a hook 62 which is engaged to a conventional electrically operated weight detector 64 which provides an electrical signal via line 66 to control unit 42 which indicates when pouch 100' is empty. Outlet 70 of bleeder block 52 is now connected to pump 71 via tube 72 and liquid photoresist is pumped continuously from pouch 100' to wafer processing unit 74.

While pouch 100' is being used to supply photoresist, a second pouch 200 on sloped shelf 33 communicates through connector 35, tube 39 and connector 41 to solenoid controlled valve 43 which is electrically connected via line 51 to control unit 42. The operator, by pressing an appropriate switch on panel 44 causes the valve associated with solenoid 43 to open. A light pressure is then applied to pouch 200 and any gas in pouch 200 which is present at location 59 is forced by liquid from pouch 200 through tube 61 into chamber 63 of manifold bleeder block 52. Pressure is maintained on pouch 200 to cause liquid photoresist to fill chamber 63 and force any gas through conduit 65 and through hand-operated valve 67. When liquid appears in transparent tube 69, valve 67 is closed and the gas is thus removed. Excess liquid passes to receptacle 73 where it can be recovered for disposal. Solenoid valve 43 is actuated from control unit 42 to close and tube 61 is disconnected from chamber 63 of bleeder block 52 and reconnected in position 61' to photoresist filled chamber 50 of block 52 via conduit 71. When pouch 100 has been emptied, a signal from weight monitor unit 64 causes control unit 42 to simultaneously close solenoid valve 38 and open solenoid valve 43 and pouch 200, in position 200', provides uninterrupted photoresist supply to pump 71. For subsequent pouch replacements, the procedure followed is to use only chamber 63 of block 52 for bleeding and disconnecting and reconnecting to chamber 50 for transmission of photoresist to pump 71. Thus, after the initial bleeding of a pouch using chamber 50, subsequent bleeding is accomplished using chamber 63, and primed, i.e., photoresist filled chamber 50, maintains the pumping system gas-free. Conduits 70, 77, 75 and 79 are all provided with conventional double ended shut off valve connectors of the type which remain closed until a tube is connected. The connecting tubes are also provided with conventional double ended quick disconnect connectors which remain closed until connected to the conduits.

While the foregoing description has been directed to liquid photoresists and collapsible pouch type containers, the present invention may be used with other types of containers and with liquid chemicals generally.

CLAIMS:

1. Dispensing apparatus for use in a liquid chemical pumping system characterized by a manifold (52) enclosing separate first (50) and second (63) chambers, said manifold (52) having two inlet ports (77, 75), an outlet port (70) and a bleeder port (54) communicating with said first chamber (50) and an additional inlet port (79) and an additional bleeder port (65) communicating only with said second chamber (63), and a pair of valves (56, 67) adapted to be opened and closed respectively connected in line with said bleeder ports (54, 65).

2. Apparatus in accordance with claim 1, characterized in that a first chemical container (100) containing liquid chemical is adapted to be removably connected through an electrically operable solenoid valve (38) to one of said inlet ports (75, 77) communicating with said first chamber (50) and wherein a second chemical container (200) containing liquid chemical is adapted to be connected through an electrically operable solenoid valve (43) to the inlet port of the second chamber (63).

3. Apparatus in accordance with claim 2, characterized in that a pump (71) is removably connected to the outlet port (70) of said first chamber (50) and is adapted to pump liquid from said first chamber (50).

4. Apparatus in accordance with claim 1, characterized in that each of said bleeder ports (54, 65) is connected to separate transparent ports (58, 69).

FIG. 1

FIG. 2

FIG. 3a

FIG. 3b